# EUROPÄISCHE PATENTSCHRIFT

(11) **EP 0 517 349 B1**
(45) Veröffentlichungstag und Bekanntmachung des Hinweises auf die Patenterteilung: **05.03.1997**
(21) Anmeldenummer: 92250142.4
(22) Anmeldetag: 05.06.1992
(51) Int. Cl.: B65G 49/04, C25D 17/06

(54) **Verfahren und Vorrichtung zum Beschicken und zum Abtransport von plattenförmigen Gut in und aus einer Galvanisieranlage.**
Method and apparatus for charging and discharging platelike products in and from a electrplaiting plant.
Procédé et appareil pour le chargement et déchargement des objets en formes plaques dans et d'une installation galvanoplastique.

(30) Priorität: 07.06.1991 DE 4118846
(43) Veröffentlichungstag der Anmeldung: 09.12.1992
(73) Patentinhaber: ATOTECH Deutschland GmbH, 10553 Berlin (DE)
(72) Erfinder: Astor, Kurt, W-8543 Hilpoltstein (DE); Budinsky, Helmut, W-8501 Winkelhaid (DE); Kauper, Rudolf, W-8501 Schwanstetten (DE); Kosikowski, Thomas, W-8501 Burgthann (DE); Kreisel, Rudolf, W-8500 Nürnberg 20 (DE); Kruse, Gerhard, W-8501 Feucht (DE); Schneider, Reinhard, W-8501 Cadolzburg 2 (DE)
(74) Vertreter: Effert, Udo, Dipl.-Ing.

(56) Entgegenhaltungen:
- EP-A- 0 261 372
- DE-A- 3 606 493
- DE-A- 3 612 220
- DE-A- 3 703 542
- GB-A- 2 031 830

## Beschreibung

Die Erfindung betrifft zunächst ein Verfahren gemäß dem Oberbegriff des Anspruches 1. In der Regel dürfen die Platten und insbesondere Leiterplatten in ihrem den eigentlichen "Nutzen" aufweisenden Bereich weder von Hand noch durch Transportmittel wie Sauger und dergleichen berührt werden (wie es beispielsweise aus DE-OS 37 03 542 bekannt ist), da dies zu Fehlern an den berührten Stellen und damit zu Ausfällen in der Produktion führen kann. Dies gilt vor allem für Leiterplatten, an deren Oberfläche Leiterbahnen und dazwischen befindliche Abstände von sehr geringer Breite vorgesehen sind. Durch eine der vorgenannten Berührungen können sich im späteren Betrieb zwischen diesen Leiterbahnen Kurzschlußstellen bilden mit der Folge, daß die gesamte Leiterplatte repariert oder weggeworfen werden muß. Man hat zwar versucht, dieses Problem dadurch zu bewältigen, daß die Platten einzeln von Hand nur an ihren Stirnkanten erfaßt und an die Warenträger angeklammert, bzw. nach dem Behandeln von den Klammern gelöst wurden. Dies bedingt aber wirtschaftlich nicht mehr vertretbare Personalkosten. Außerdem dauert das manuelle Anbringen der Platten an den Warenträgern, sowie das entsprechende Abnehmen relativ lange, wobei der betreffende Warenträger während der gesamten Be- oder Entladezeit hierfür zur Verfügung stehen muß, d.h. nicht zum Transport der Ware von der Beladestation zu den Behandlungsstationen, in der Zeit während der Behandlung in den Behandlungsstationen der Anlage und für den Transport von dort zurück zur Entladestation eingesetzt werden kann. Dies aber mindert, bei sonst gleichen Bedingungen, die Kapazität einer hiermit ausgerüsteten Anlage. Schließlich sind bei einer manuellen Betätigung Fehler der Bedienungspersonen nicht auszuschließen, die zu einer Beschädigung von Platten führen können.

In der eingangs genannten DE-OS 37 03 542 ist zwar erwähnt, daß zu galvanisierenden Platten an senkrecht verlaufenden Traggestellen dadurch gehalten sind, daß federnde Klammern dieser Traggestelle die Ränder der zu galvanisierenden Platten erfassen und damit die Platten halten. Zum einen betrifft dies nicht den Oberbegriff des Anspruches 1, wonach die Platten an Klammern von Warenträgern gehalten werden. Insbesondere ist der vorgenannten Literaturstelle nicht die nachstehend zu erläuternde Lehre der Erfindung zu entnehmen. Vielmehr ist beim Gegenstand der DE-OS 37 03 542 für den Transport der Platten vorgesehen, daß die eingangs bereits erwähnten Sauger am Nutzen der Platten angreifen, wobei die zu behandelnden Platten zunächst eine waagerechte Lage einnehmen und von dieser in eine senkrechte Behandlungslage gebracht werden.

Aus DE-PS 36 12 220 sind lediglich Haltezangen zum klemmenden Erfassen von Platten oder plattenförmigen Teilen bekannt, die vom Warenträger herunterhängend die zu galvanisierenden Platten an ihren Rändern angreifen. Auch hieraus ist nicht die Lehre der Erfindung zu entnehmen, denn diese Literaturstelle betrifft nur das Erfassen von Platten für deren Eintauchen und Herausnehmen in bzw. aus galvanischen Bädern; nicht aber für und während der Transportes von Platten von ihrer Anlieferstelle bis zum Anhängen am Warenträger. Das gleiche gilt für die Literaturstelle EP-0 261 372. Die dort gezeigten Zangen dienen ebenfalls in üblicher Weise zum Transport einer an einem Warenträger bereits angehängten Ware entlang eines Badbehälters oder durch diesen Badbehälter. Auch dies ist nicht mit der nachstehend näher zu erläuternden Lehre der Erfindung vergleichbar.

Die Aufgabe der Erfindung besteht zunächst demgegenüber darin, bei einem Verfahren gemäß dem Oberbegriff des Anspruches 1 die erläuterten Beschädigungen der Platte zu vermeiden und dabei gleichzeitig eine weitgehend automatisierte Fertigung zu erreichen.

Die Lösung dieser Aufgabe wird zunächst, ausgehend vom Oberbegriff des Anspruches 1, in den Merkmalen des Kennzeichens des Anspruches 1 gesehen. Unter den Galvanorändern werden die umlaufenden Ränder einer zu galvanisierenden oder analog chemisch zu behandelnden Platte verstanden, die den sogenannten Nutzenbereich umgeben und in der Regel bis zu 15 mm breit sind. Diese Galvanoränder sind an beiden Seiten der Platten vorgesehen. Erst innerhalb dieser Galvanoränder beginnt der für die Galvanisierung oder dergleichen vorgesehene Bereich (Nutzen) der jeweiligen Plattenseite. Mit der Erfindung werden diese Galvanoränder für die weitgehend automatisierte Anbringung der Platten am Warenträger, sowie der Ablösung der Platten nach erfolgter Behandlung und den zugehörigen Transport ausgenutzt. Fehler durch manuelle Betätigungen entfallen. Insbesondere bleibt der innerhalb des Galvanorandes befindliche Bereich beider Seiten der Platten dabei unberührt. In der bevorzugten Ausführungsform der Erfindung behalten die Platten von ihrer Ausgangsposition her bis zum Anhängen am Warenträger stets eine senkrechte Lage bei. Dies erleichtert den Transportvorgang zusätzlich. In Sonderfällen kann aber auch von einer anderen, nicht senkrechten Ausgangslage der Platten ausgegangen werden.

Während der Zeit des Transportes der Platten in die Position, aus der sie für die Anklammerung am Warenträger hochgefahren werden, steht der betreffende Warenträger für den Transport anderer Platten zur jeweiligen Behandlungsstation, bzw. von der Behandlungsstation zurück an eine Entladestation zur Verfügung. Der Warenträger muß sich lediglich für die sehr kurze Zeit in der Beladestation oder der Entladestation in der Position befinden, in der die Platten an ihn angeklammert oder aus der Abklammerung gelöst werden. In dem Zusammenhang empfiehlt sich gemäß Anspruch 2 eine Abstimmung der vorgenannten Belade- und Entladezeiten einerseits und den Zeiten für das Hin- und Herfahren der Warenträger zwischen den einzelnen Stationen andererseits.

Die Erfindung sieht ferner eine Vorrichtung gemäß dem Oberbegriff des Anspruches 3 vor. Hinsichtlich des Standes der Technik wird auf die vorstehenden Ausführungen verwiesen. Die Aufgabe der Erfindung besteht zunächst darin, eine solche Anordnung so auszugestalten, daß unter Vermeidung der Berührung oder Beschädigung von zu galvanisierenden Flächenbereichen (Nutzen) der Platten, deren Transport, sowie deren Anbringung am bzw. Ablösung vom Warenträger möglichst schnell, automatisiert bzw. automatisierbar und dabei mit relativ einfachen Mitteln erfolgen kann.

Zur Lösung dieser Aufgabe sind, ausgehend vom Stand der Technik gemäß Oberbegriff des Anspruches 3, die Merkmale des Kennzeichens des Anspruches 3 vorgesehen. Abgesehen vom Überwachungspersonal ist weiteres Personal nicht notwendig, da die zum Stand der Technik erläuterte Handarbeit und die hiermit verbundenen Nachteile entfallen. Desgleichen sind Sauger oder ähnliche Transport- oder Hubmittel vermieden, die an den zu galvanisierenden Flächen der Platte angreifen. Das Ergreifen der zu transportierenden Platten nur an ihren Rändern ist konstruktiv mit der Erfindung relativ leicht zu verwirklichen und zwar insbesondere dann, wenn dabei die Platten schon in ihrer Ausgangslage senkrecht verlaufen. In den vorstehend bereits erwähnten Sonderfällen können die Platten aber auch aus einer nicht senkrechten Ausgangsposition her in eine senkrechte Behandlungsposition bewegt werden.

Weitere Ziele der Erfindung sind die Ausbildung der Zuführung der Platten zur Beladestation, der Beladestation selber, entsprechender Entladestationen und von Vorrichtungen, welche die Platten nach Verlassen der Entladestation in eine horizontale Lage und von dort zu einer Ablage bringen. Sich mit dem vorstehenden Ziele befassende, vorteilhafte Anordnungen und Merkmale der Erfindung ergeben sich aus den weiteren Ansprüchen.

Im übrigen werden die Inhalte der Ansprüche und weitere Ausgestaltungen der Erfindung nachfolgend in Verbindung mit den Erläuterungen von Ausführungsbeispielen der Erfindung anhand der Zeichnung näher erläutert. In der im wesentlichen schematischen Zeichnung zeigt:
- Fig. 1:: In der Seitenansicht eine Beladestation der Erfindung mit einer Aufgabestation zur Zuführung der Platten in der Seitenansicht,
- Fig. 2:: Die Draufsicht auf Fig. 1,
- Fig. 3:: In der Draufsicht eine teilweise Darstellung einer Belade- und einer Entladestation nebeneinander,
- Fig. 4:: in Blockdarstellung eine Variante der Erfindung,
- Fig. 5:: eine Einzelheit der Erfindung im vergrößerten Maßstab und in der Seitenansicht,
- Fig. 6:: die Einzelheit der Erfindung gemäß Fig. 5 in einer anderen Position.
- Fig. 7:: eine Entladestation mit Ablage in der Seitenansicht,
- Fig. 8:: die Draufsicht auf Fig. 7.

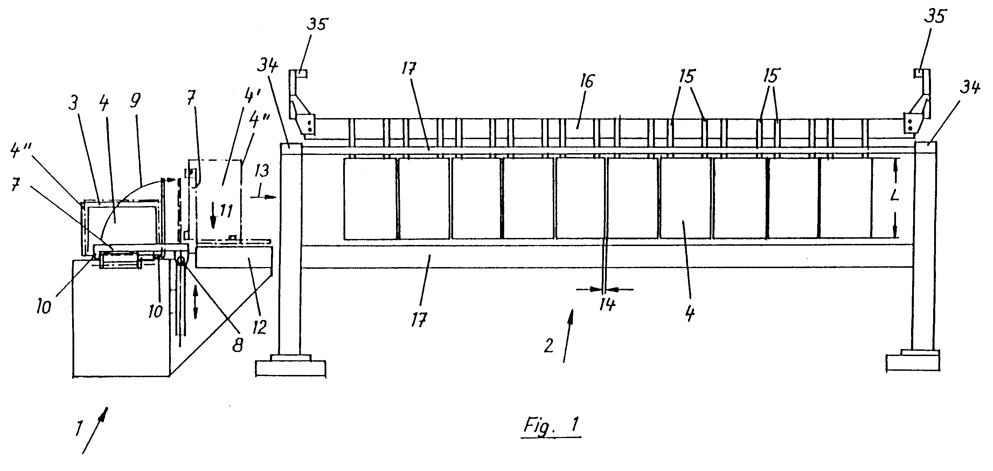

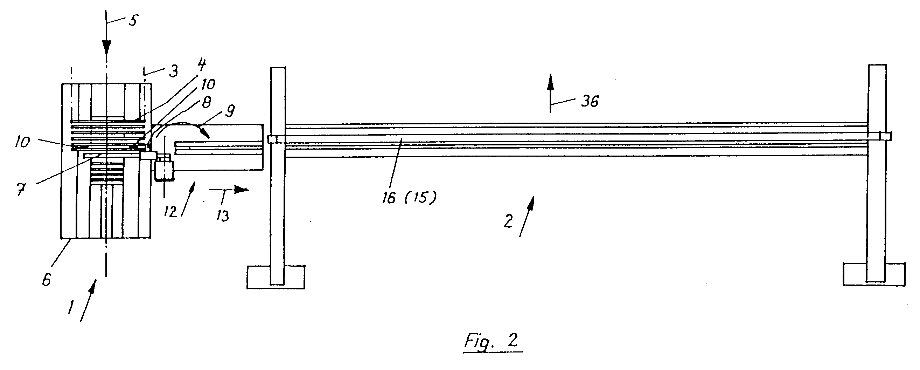

Fig. 1 und 2 zeigen die Aufgabestation 1 und die Beladestation 2 in einer bevorzugten Gestaltung der Erfindung mit Platten in einer senkrechten Ausgangsposition. Hierzu ist eine Kassette 3 mit senkrecht stehenden Platten 4 bestückt, die in der Einschubrichtung 5 der Kassette in Abständen und hintereinander angeordnet sind. Die Kassette 5 wird dabei in einer Führung 6 geführt. Ein Schwenkmittel, hier in Form eines Schwenkarmes 7, der um die Achse 8 gemäß dem Pfeil 9 schwenkbar ist, befindet sich an der Führung 6. Der Schwenkarm 7 weist Hubmittel in Form von Zapfen 10 auf, die unterhalb der Bewegungsbahn der Platten 4 liegen. Die Platten 4, im Ausführungsbeispiel hochempfindliche Leiterplatten, werden taktweise in eine Position gebracht, in der sie beim Schwenken des Armes 7 aus der waagerechten Lage gemäß Fig. 1 in die strichpunktiert dargestellte Lage 4' gebracht werden, indem mittels der Zapfen 10 die jeweils über ihnen befindliche Platte 4 an deren Stirnkanten und damit im Bereich des Galvanorandes 4'' ergriffen und in die in Fig. 1 strichpunktiert dargestellte Lage 7' gebracht wird. Der Galvanorand 4'' der Platte 4 ist in Fig. 1 angegeben. Er läuft an beiden Seiten der Platte um. Zu ihm gehört funktionell auch die jeweilige Stirnkante der Platte, an der im vorliegenden Ausführungsbeispiel die Zapfen 10 angreifen.

Nach dem Schwenken der Platte 4 in die strichpunktierte Darstellung 4' in Fig. 1 rutscht sie gemäß Pfeil 11 in Förder- und Transportmittel 12, die in Fig. 1 nicht gesondert dargestellt sind, jedoch den Greif- und Transportmitteln der Be- und Entladestation entsprechen.

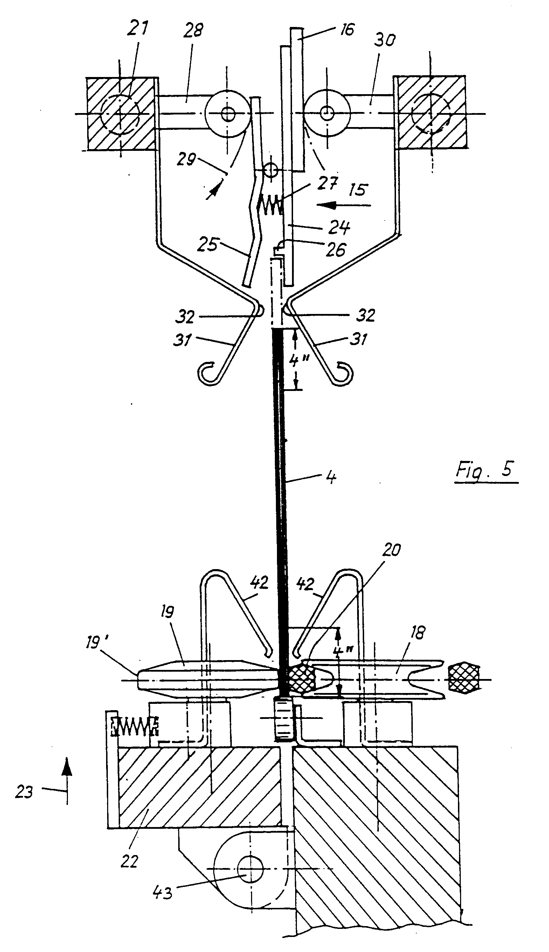

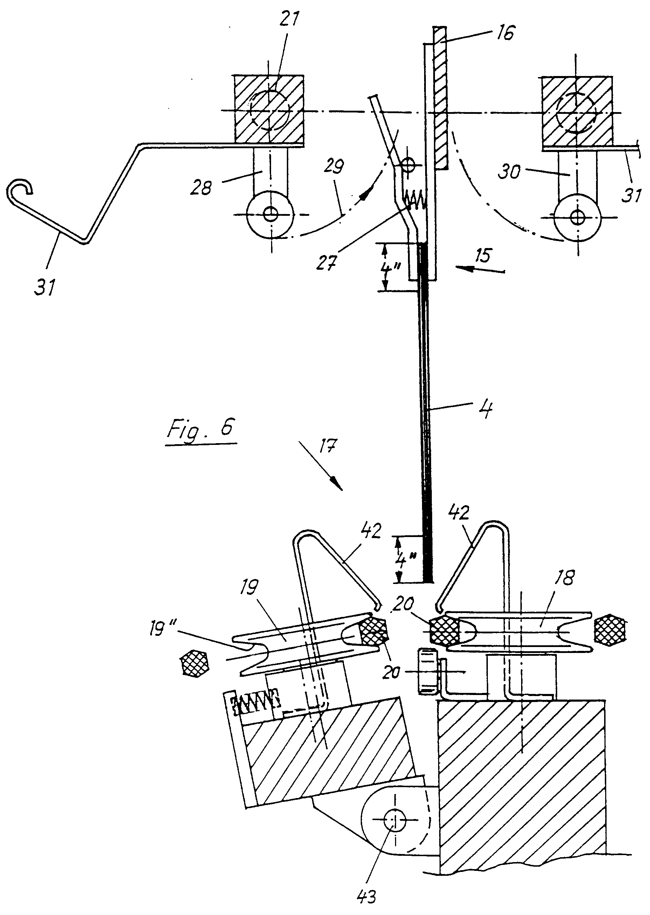

In der Beladestation 2 werden die Platten 4 den Greif- und Transportmitteln (siehe im einzelnen Fig. 5 und 6) zugeführt, wobei sie senkrecht stehen (siehe ebenfalls Fig. 5 und 6). Der Abstand 14 zwischen den aufeinander folgenden Platten 4 ist eingestellt und auf die Abstände und Position der schematisch mit 15 angedeuteten Klammern des Warenträgers 16 derart abgestimmt, daß bei der nachfolgend zu erläuternden Anklammerung der Platten 4 jede dieser Platten sich in der richtigen Lage zu den ihr zugeordneten Klammern 15 befindet. Die Positionierung der Platten und die Größe der vorgenannten Abstände voneinander sind durch Lichtschranken, Sensoren oder dergleichen Erfassungs- und Steuermittel der Anlage den jeweiligen Anforderungen entsprechend einstellbar. Es können auch Platten 4 unterschiedlicher Breite transportiert und behandelt werden. Es ist dann lediglich dafür zu sorgen, daß die Klammern 15 in einer solchen Lage am Warenträger 16 befestigt sind, daß auch die Platten unterschiedlicher Breite von den Klammern erfaßt und gehalten werden können.

Analoge Erfassungs- und Steuermittel können auch für die weiteren, nachstehend erläuterten Vorgänge der Anordnung nach der Erfindung vorgesehen sein und zwar auch dann, wenn solche Erfassungs- und Steuerungsmittel nicht jeweils gesondert erwähnt sind. Das gleiche gilt für notwendige Fertigmeldungen, Fehlermeldungen und Rückkopplungen mit anderen Steuerelementen. Sofern erforderlich sind Lesegeräte zum Lesen eines Code vorgesehen, der sich an den Platten befindet.

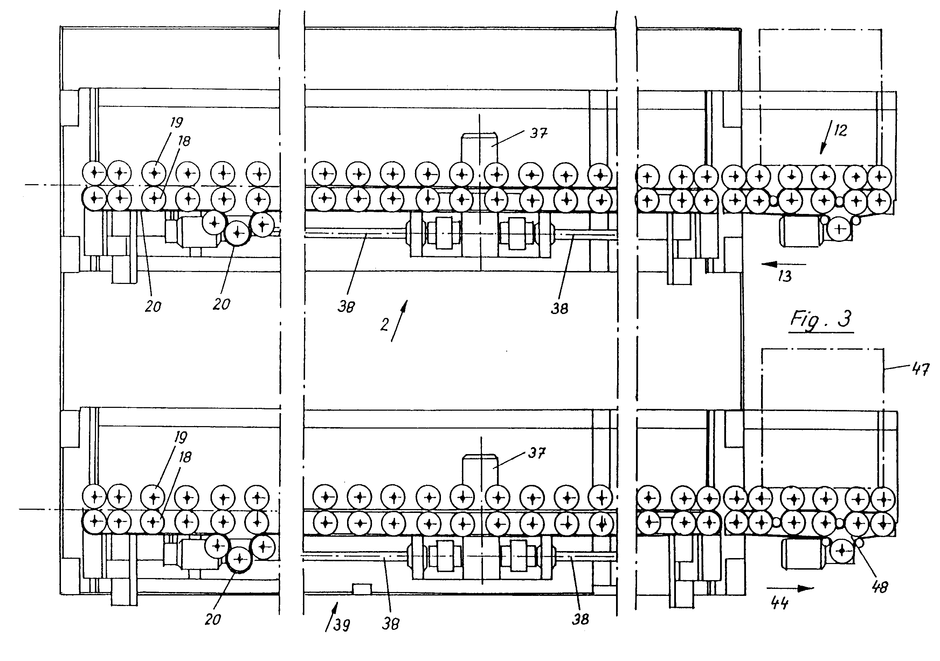

Die Greif- und Transportmittel der Beladestation 2 (und auch der übrigen Stationen 2', 39) sind schematisch in Fig. 1, 2 mit der Ziffer 17 bezeichnet und in ihren Einzelheiten den Fig. 3, 5 und 6 zu entnehmen. Es ist jeweils ein Paar von zusammenwirkenden Rollen 18, 19 vorgesehen, wobei die Rollen 18 einen um sie umlaufenden Transportriemen 20 führen, der an der einen Seite der Platte 4 anliegt. An der anderen Seite der Platte 4 liegt als Gegenlager die Rolle 19 an. Somit hat für den unten gelegenen Galvanorand 4'' der Platte 4 die Rolle 18 in Verbindung mit dem Riemen 20 die Funktion des Greifens, Haltens und ferner des Transportes in Pfeilrichtung 13, während die Rolle 19 für diesen unteren Galvanorand 4'' nur die Funktion des Haltens und Greifens, sowie eines Gegenlagers hat. Dies ist in Fig. 5 dargestellt. Dabei ist die links gezeichnete Rolle 19 mit einer Stirnfläche 19' versehen, welche das vorgenannte Gegenlager bildet. Es kann aber, falls erwünscht, auch eine Variante gemäß Darstellung in Fig. 6 vorgesehen werden, wobei an der dort links gezeichneten Rolle 19 und den in der Zeichenebene hinter bzw. vor ihr liegenden Rollen 19 ein Förderband 20 mit umläuft. In diesem Fall wird der unten gelegene Galvanorand 4'' in der Halteposition zwischen den beiden einander gegenüberliegenden Trums der beiden Förderbänder 20 eingeklemmt. Ferner ist in diesem Fall die Rolle 19 an ihrem Umfang mit einer Hohlkehle 19'' für die Führung des Förderbandes 20 versehen. In diesem Fall kann eines der Förderbänder oder es können auch beide Förderbänder angetrieben sein, wobei im letztgenannten Fall für eine Synchronität zu sorgen ist. Die Rollen 18, 19 laufen um senkrechte Achsen um. Die Greif- und Transportmittel 17 befinden sich zunächst in einer in Fig. 5 dargestellten unteren Position, in der sich der oben gelegene Galvanorand 4'' einer Platte 4 noch nicht im Greifbereich der Klammern 15 befindet. Die Greif- und Transportmittel sind an einem Hubmechanismus, z.B. einem Hubbalken 22 angebracht, der in Pfeilrichtung 23 soweit nach oben bewegbar ist, daß er diese Greif- und Transportmittel zusammen mit den von ihnen gehaltenen Platten 4 soweit nach oben bewegt, bis der oben gelegene Galvanorand 4'' sich in der in Fig. 5 strichpunktiert dargestellten Lage befindet, in der er von den Klammerarmen 24, 25 erfaßt wird (siehe Fig. 6) Diese Lage kann, z.B. durch eine Lichtschranke oder einen Stoppanschlag 26 mit Abschaltelement definiert sein.

Die beiden Klammerarme 24, 25 sind durch eine Feder 27 in die Klemmlage gemäß Fig. 6 bringbar. Durch ein Druckstück 28 kann unter Zusammendrückung der Feder 27 aus der Schließstellung der Fig. 6 die Offenstellung der Fig. 5 erreicht werden. Da auf die Länge des Warenträgers 16 verteilt eine ganze Reihe von Klammern 15 vorgesehen und für jede dieser Klammern ein Druckstück 28 erforderlich ist, empfiehlt es sich, hierfür eine gemeinsame Betätigung vorzusehen, z.B. in Form einer sich in Längsrichtung des Warenträgers 16 erstreckenden Druckstange 21, die in Pfeilrichtung 29 um ihre Längsachse schwenkbar ist. Um hierbei ein etwaiges Durchbiegen des Warenträgers zu verhindern, sind entsprechende Gegendruckstücke 30 vorgesehen, die an der dem Druckstück 28 abgewandten Seite des Warenträgers anliegen. Die Klammern 15 sind mit ihrem Arm 24 am Warenträger 16 befestigt.

Um den Platten 4 während ihres Transportes innerhalb der Beladestation 2 eine Sicherung gegen ein Abkippen zur Seite hin zu geben, sind Kippsicherungen 31 vorgesehen, die mit einer vorspringenden Kante 32 versehen sind. Diese Kanten befinden sich in der Nähe zu bzw. im Berührungskontakt mit dem oben gelegenen Galvanorand 4''. Der Vergleich von Fig. 5 zu Fig. 6 zeigt, daß wenn sich die Teile 31 in dieser Position der Kippsicherung befinden, dann die Klammern 15 geöffnet sind (Fig. 5), während beim Schließen der Klammern 15 die Teile 31 zur Seite geschwenkt sind, d.h. den oberen Galvanorand 4'' freigeben. Zugleich haben die Greif- und Transportmittel 17 die in Fig. 6 unten dargestellte Position eingenommen, in der sie den unten gelegenen Galvanorand 4'' freigeben. Die vorgenannten Bewegungen sind zwangsläufig miteinander gekoppelt. Die Umschaltung von der Position der Teile gemäß Fig. 5 in die Position gemäß Fig. 6 erfolgt dann, wenn durch die Hubbewegung 23 alle Platten 4 die Klammerhöhe erreicht haben. Da die Platten 4 durch die Klammern 15 fest gehalten sind, haben sich danach die Greif- und Transportmittel in die Position der Fig. 6 nach unten abgesenkt und die in Fig. 5 dargestellte Lage eingenommen. Zugleich kann der Warenträger 16, der auf Einweisungen des Rahmens 34 aufliegt, mittels Transportwagen (nicht dargestellt) an den Vorsprüngen 35 erfaßt und abgehoben und gemäß Pfeil 36 (Fig. 2) zur jeweiligen Behandlungsstation usw. der Galvanisieranlage oder dergleichen transportiert werden.

Es ist ersichtlich, daß in einer Charge der Beladestation nur Platten der gleichen Länge L gehalten und an den Klammern 15 angebracht werden, da die Platten 4 jeweils vom Hubbalken 22 und den Greif- und Transportmitteln nach oben gehoben werden müssen, diese aber aus praktischen Gründen die gleiche Höhenlage haben. Die Anordnung ist aber nicht darauf beschränkt, nur Platten einer bestimmten Länge L an dem Warenträger anzubringen bzw. von dem Warenträger lösen zu können. Es kann auch eine Charge von Platten an dem Warenträger angebracht werden, deren Länge L unterschiedlich von der Länge L einer anderen Charge von Platten ist. Hierzu ist es lediglich notwendig, das Maß des Hubes 23 der unteren Greif- und Transportmittel 17 entsprechend an die jeweilige Länge L der Platten einer Charge anzupassen.

Die Klammern 15 liegen etwas höher als die Kanten 32, wobei aber dafür gesorgt ist, daß beim Auf- und Abwärtsbewegen der Platten 4 die Kanten 32 nur am oben gelegenen Galvanorand 4'' gleiten können.

Sobald der Warenträger 16 mit den von seinen Klammern 15 herunterhängenden Platten abgehoben und gemäß Pfeil 36 wegbewegt wurde, erfolgt eine Kontrolle, ob auch sämtliche der Beladestation zugeführten Platten vom Warenträger abgehoben wurden oder, z.B. wegen eines Defektes der Klammern, eine oder mehrere Platten sich noch in den Greif- und Transportmitteln der Beladestation befinden. Hierzu können die letztgenannten Transportmittel in Bewegung gesetzt werden.

Eine Lichtschranke am Ende der Beladestation 2 kontrolliert dann, ob noch Platten vorhanden sind. Bejahendenfalls werden diese gesondert abgelegt und, sofern sie einwandfrei sind, wieder der Kassette 3 zugeführt.

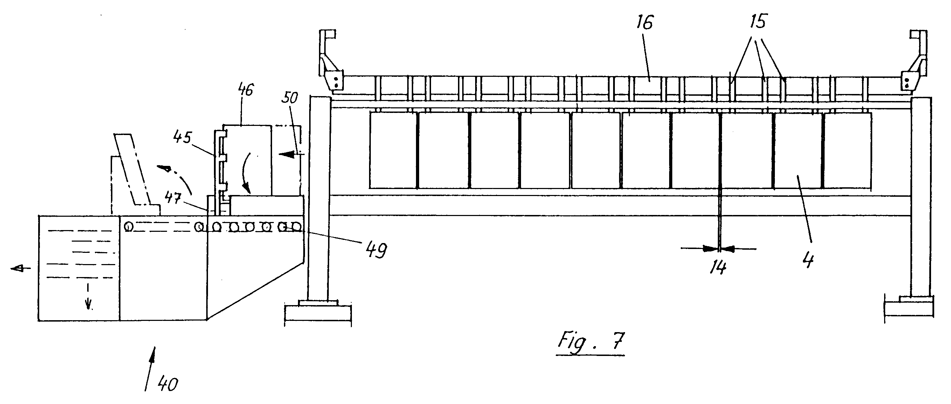

In der nur einen Teil der Draufsicht darstellenden Fig. 3 ist die Beladestation 2 mit den Rollen 18, 19 und dem Transportriemen 20 dargestellt. Der Hubmotor 37 sorgt über ein Gestänge 38 und hier nicht gesondert dargestellte Hubmittel dafür, daß die Hubbewegung in Richtung des Pfeiles 23 erfolgt. Parallel und im Abstand zur Beladestation 2 ist eine Entladestation 39 vorgesehen, die hinsichtlich der Rollen 18, 19 und des Riemens 20 der Bauweise der Beladestation 2 entspricht. Dies gilt auch hinsichtlich der Ausgestaltung der Mittel, die in den Fig. 5 und 6 im einzelnen dargestellt sind und vorstehend erläutert wurden. Nur ist in der Entladestation 39 der Ablauf genau umgekehrt, indem die Warenträger 16 mit den an den Klammern 15 hängenden, behandelten Platten 4 von oben auf die Einweisungen des Rahmens 34 abgesenkt werden und oberhalb der Greif- und Transportmittel dieser Entladestation gebracht werden. Dann werden die Greif- und Transportmittel nach oben bewegt, bis sie die Platten an ihrem unten gelegenen Galvanorand 4'' klemmend erfassen. Danach erfolgt das Öffnen der Klammern 15 mit gleichzeitigem Bewegen der Kippsicherungen 31 in ihre Sicherungsposition und nachfolgendem Absenken der Greif- und Transportmittel mit den Platten 4. Die Platten werden dann von den Greif- und Transportmitteln jeweils taktweise in Pfeilrichtung 50 (Fig. 7) weitertransportiert. Ein Takt entspricht der Breite einer Platte 4, zuzüglich des zwischen ihr und der nächstfolgenden Platte bestehenden Abstandes. Sobald die Kippsicherungen 31 in Funktion sind, sind die Klammern 15 offen. Der Warenträger 16 kann abgehoben und wieder einer anderen Station zugeführt werden.

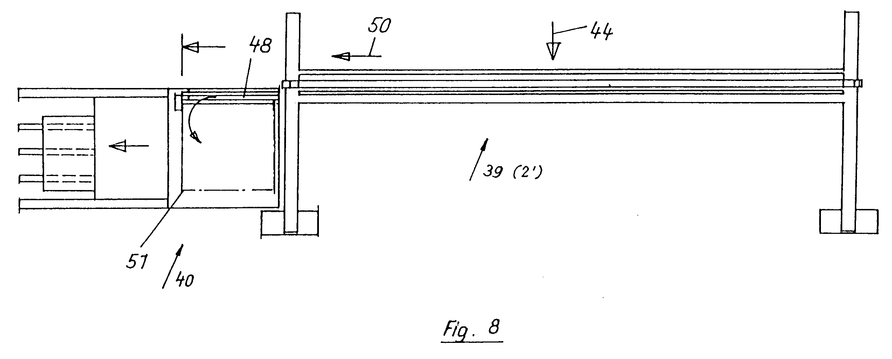

Aus Vorstehendem ergibt sich besonders, daß der jeweilige Warenträger 16 nur sehr kurzfristig in der Beladestation 2 bzw. der Entladestation 39 verweilen muß, da das Anklammern der Platten und das Loslösen der Platten am bzw. vom Warenträger sehr schnell vor sich geht. Während der Bewegung des Warenträgers mit den Platten zur Behandlungsstation usw. und zurück besteht genügend Zeit zur Beschickung der Beladestation mit Platten, bzw. der Abführung der in der Entladestation 39 abgeladenen, behandelten Platten. Diese werden taktweise der nachstehend näher zu erläuternden Ablagestation 40 zugeführt (siehe Fig. 7 und 8).

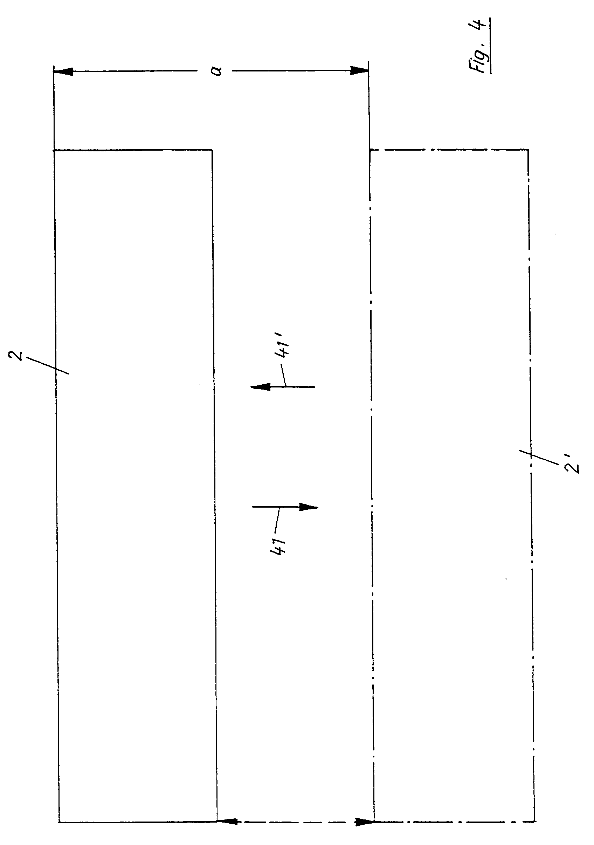

Statt einer gesonderten Beladestation 2 und einer gesonderten Entladestation 39 (siehe Fig. 3) kann auch so vorgegangen werden, daß die Beladestation 2 gemäß Fig. 4 aus der mit durchgezogenen Linien schematisch gezeichneten Stellung für das Beladen mit den Platten, um einen Weg a in Richtung des Pfeiles 41 in die strichpunktiert dargestellte Position 2' verschoben werden kann und dann die Funktion der Entladestation hat. Es versteht sich, daß die Positionen 2 und 2' gemäß Fig. 4 so zu den in Fig. 4 nicht gezeichneten Mitteln zum Antransport der Platten zur Beladestation, sowie zum Abtransport der Platten von der Entladestation plaziert sind, daß der Beladevorgang und der Entladevorgang wie beschrieben reibungslos vor sich gehen kann. Ebenso ist dafür gesorgt, daß der oder die Warenträger für das Beladen die entsprechende Postion zur Stellung 2 und für das Entladen die entsprechende Position zur Stellung 2' einnehmen. Nur muß bei der Steuerung der Plattenzufuhr und -abfuhr und der Bewegung der Warenträger berücksichtigt werden, welche Position die Station einnimmt (2 oder 2'), an der er Platten aufnehmen oder ablegen soll. Entsprechend werden die Hinbewegung 2-2' gemäß Pfeil 41 und die Rückbewegung 2'-2 gemäß Pfeil 41' gesteuert.

Eine weitere Variante der Erfindung besteht darin, daß ein und dieselbe Station in der oberen und der unteren Position der Fig. 4 jeweils entweder nur Beladestation ist oder nur Entladestation. Auch können in einer Anlage mehrere Gruppen von den zuletzt genannten Stationen, oder auch mehrere Gruppen aus je einer Belade- und Entladestation vorgesehen sein. Der vorgenannte Abstand a, um den die betreffende Station verschoben wird, kann beispielsweise 400 mm betragen. Diese Variante der Erfindung empfiehlt sich auch für den Einsatz von Doppelwarenträgern, d.h. von zwei Warenträgern, die an einem gemeinsamen Transportwagen hängen, wodurch Transportwagenkapazität gespart wird. Der Abstand zwischen diesen beiden Warenträgern ist dann gleich dem Abstand a gemäß Fig. 4.

Im Falle der Entladestation, bzw. im Falle der verschiebbaren Station gemäß Fig. 4 empfiehlt es sich, oberhalb der Greif- und Transportmittel 18-20 Einweisungen 42 vorzusehen, welche für das Einsetzen der behandelten Platten schräg zu deren Abwärtsbewegung laufen, dabei aufgrund der vorgenannten Schräganordnung nur am Galvanorand 4'' angreifen und die Platten 4 in die gewünschte Position zwischen Riemen 20 und Rollen 19 bringen. Der in den Fig. 5, 6 links unten gezeigte Teil der Greif- und Transportmittel mit der Rolle 19 ist zum Einführen der Platte 4 um eine Achse 43 nach außen wegschwenkbar (siehe Fig. 6).

Fig. 8 zeigt, wie die behandelten Platten vom Warenträger gemäß Pfeil 44 der Entladestation 39 bzw. 2' zugeführt wurden. Nach der Übergabe vom Warenträger an die Greif- und Transportmittel der Entladetation 39 bzw. 2' werden die Platten taktweise in Pfeilrichtung 50 der Abgabestation 40 zugeführt und dort mittels einer Vorrichtung 45 aus der senkrechten Position 46 durch Schwenkung der Vorrichtung 45 um eine Achse 47 in eine waagerechte Lage gebracht, die in Fig. 8 mit 51 beziffert ist. Die Vorrichtung 45 hat für den Halt der jeweiligen Platte in der senkrechten Lage Führungsmittel 48, die in etwa den Führungen 12 der Aufgabestation 1 entsprechen. Nach der Schwenkung der jeweiligen Platte um 90° wird sie auf Rollen 49 oder sonstigen Ablagemitteln abgelegt, z.B. ein Förderband. Diese Aufnahme je einer Platte durch die Vorrichtung 45 und deren Schwenkung um 90° geschieht taktweise, d.h. die Platten werden in Pfeilrichtung 50 je für sich taktweise der Vorrichtung 45 zugeführt. In diesem Stadium ist nach erfolgter Galvanisierung aufgrund der dadurch gebildeten Leiterbahnen eine Berührung der galvanisierten Oberflächen durch Förderrollen oder dergleichen unschädlich. Auch hier können Lichtschrankensteuerungen vorgesehen sein.

Am Ausgang der jeweiligen Entladestation 39 bzw. 2' kann anstelle der an Hand der Fig. 7 und 8 beschriebenen Abgabestation 40 auch eine Abgabestation vorgesehen sein, welche die Platten in senkrechter Position ablegt, z.B. in Kassetten gemäß der Kassette 3, die an Hand der Aufgabestation 1 in den Fig. 1 und 2 dargestellt und in dem Zusammenhang erläutert ist.

Der Vollständigkeit halber sei erwähnt, daß es ggf. auch möglich ist, die Plattenzufuhr anders als zur Station 1 beschrieben und den Plattenabtransport auch anders als zu Station 40 erläutert vorzusehen.

## Patentansprüche

1. Verfahren zum Transportieren und Übergeben Von chemisch zu behandelnden Platten (4), insbesondere von Leiterplatten, zu und an Warenträger (16), die Klammern (15) zum lösbaren Halt der Platten aufweisen, sowie zur Abnahme der behandelten Platten vom Warenträger und zu deren Abtransport, dadurch gekennzeichnet, daß die bevorzugt in senkrechter Lage oder in Sonderfällen aus einer nicht senkrechten Ausgangsposition her, in eine senkrechte Behandlungsposition angelieferten Platten, in dieser Lage durch maschinelle Erfassung lediglich an ihren Galvanorändern (4'') vereinzelt und hintereinander in einen definierten Abstand (14) zueinander durch horizontales Fördern mittels von am unteren Galvanorand angreifenden Fördermitteln (19,20) unter einen Warenträger (16) transportiert werden, wobei diese definierten Abstände auf die Abstände und Position der Klammern (15) des Warenträgers (16) abgestimmt sind, daß anschließend alle vereinzelten Platten (4) gemeinsam gehoben und jeweils durch die Klammern (15) des Warenträgers (16) am oberen Galvanorand erfaßt werden und daß nach Behandlung der Platten in den Behandlungsstationen einer chemischen oder galvanischen Anlage im Prinzip die vorstehend erläuterten Maßnahmen, jedoch im umgekehrten Funktionsablauf durch zunächst Lösen der Platten vom Warenträger, Erfassen und Absenken sowie taktweisen Weitertransport mittels der am unteren Galvanorand angreifenden Fördermittel zu einer Ablage (40), erfolgen.

2. Verfahren nach Anspruch 1, gekennzeichnet durch eine Abstimmung der Entlade- und Beladezeiten der Platten in einer Beladestation (2) und in einer Entladestation (39, 2') mit der Zeitfolge der Zulieferung und Abholung der Warenträger.

3. Vorrichtung zum Transportieren und Übergeben von chemisch zu behandelnden Platten (4) insbesondere von Leiterplatten, mit einer Beladestation (2) und einer Entladestation (39), wobei die Platten an der Beladestation einem von einem Transportwagen bewegten Warenträger (16) zugeführt und zu der chemischen Behandlungsstation gebracht und nach der Behandlung an die Entladestation überführt werden, um die Platten von den jeweiligen Warenträgern, an denen sie mittels Klammern (15) lösbar befestigt sind, abzunehmen, dadurch gekennzeichnet, daß die Stationen (2,39) Fördermittel (12) aufweisen, mit denen die Platten aus bevorzugt einer senkrechten Anlieferungsposition an ihrem Galvanorand ergriffen werden die Beladestation Mittel zum Einhängen und wieder Abheben eines Warenträgers aufweist, der unterseitig Klammern (15) zum Erfassen des oberen Galvanorandes der Platten besitzt, daß unterhalb der Einhängeposition des Warenträgers Greif- und Transportmittel (18-20) zum gemeinsamen Erfassen aller für den Warenträger bestimmten senkrechten Platten vorgesehen sind, ein Hubmechanismus (22,23) zum Anheben der Greif- und Transportmittel und der von ihnen darin gemeinsam gehaltenen Platten für die Bestückung eines Warenträgers in die Position zum Anklammern des oben gelegenen Galvanorandes der Platten am Warenträger vorgesehen ist, und daß die Entladestation in ihrer Bauweise der der Beladestation entspricht.

4. Vorrichtung nach Anspruch 3, dadurch gekennzeichnet, daß sich in einer Aufgabestation (1) die Platten (4) senkrecht stehend, z.B. in einer Kassette (3) befinden, daß ein parallel zu der Ebene der Platten vorgesehenes Schwenkmittel (7, 10) vorgesehen ist, das lediglich am Galvanorand (4'') der jeweiligen Platten angreifende Teile (10) aufweist, und daß in Verlängerung der Ebene der jeweils im Schwenkmittelbereich vorgesehenen Platte eine zur Beladestation (2) führende Fördervorrichtung (12) vorgesehen ist, wobei die Fördermittel der Fördervorrichtung nur an einem Galvanorand (4'') der jeweiligen Platte (4) angreifen.

5. Vorrichtung nach Anspruch 4, dadurch gekennzeichnet, daß als Fördermittel an einer Seite des unten gelegenen Galvanorandes (4'') ein umlaufendes Förderband und an der anderen Seite des Galvanorandes eine dagegen drückende Andruckrolle angreifen, oder der Andruck durch ein zweites umlaufendes Förderband erfolgt.

6. Vorrichtung nach Anspruch 4 oder 5, dadurch gekennzeichnet, daß die Kassette (3) sich mit den Platten (4) taktweise in einer Richtung (5) verschiebt, die senkrecht zur Förderrichtung (13) der Platten von der Aufgabestation (1) zur Beladestation (2) verläuft, wobei mit jedem Takt eine Platte in den Schwenkbereich des Schwenkmittels (7, 10) gelangt.

7. Vorrichtung nach einem der Ansprüche 3 bis 6, dadurch gekennzeichnet, daß automatische Steuerungen der Bewegungen der Platten und der hierfür notwendigen Bauteile, zumindest der Beladestation (2) und der Entladestationen (39, 2'), bevorzugt auch der Aufgabestation (1) und der Ablagestation (40) vorgesehen sind.

8. Vorrichtung nach einem der Ansprüche 3 bis 7, dadurch gekennzeichnet, daß Erfassungs- und Steuermittel, z.B. Lichtschranken oder Sensoren, vorgesehen sind, welche die Positionierung der Platten (4) unterhalb der Warenträger (16) und deren Klammern (15) und die Größe der hierzu erforderlichen Abstände (14) zwischen den Platten einstellen.

9. Vorrichtung nach einem der Ansprüche 3 bis 8, dadurch gekennzeichnet, daß die Beladestation (2) an jeder Seite neben dem Warenträger (16) Kippsicherungen (31, 32) aufweist, die zueinander hin in eine den oben gelegenen Galvanorand (4'') der Platte führende Position und voneinander weg in eine die Platte freigebende und nicht sichernde Position schwenkbar sind, und daß die Kippsicherungen derart geformt sind (32), daß sie bei jeder Hublage der Platte (4) nur deren oberen Galvanorand berühren.

10. Vorrichtung nach Anspruch 9, gekennzeichnet durch einen Schrägverlauf der Kippsicherungen mit einer nur am Galvanorand (4') zur Anlage kommenden Führungskante (32).

11. Vorrichtung nach einem der Ansprüche 7 bis 10, dadurch gekennzeichnet, daß die automatische Steuerung sowohl synchron die Klammern (15) des Warenträgers (16) schließt und die Kippsicherungen (31, 32) öffnet, als auch synchron die vorgenannten Klammern öffnet und die Kippsicherungen schließt.

12. Vorrichtung nach einem der Ansprüche 7 bis 11, dadurch gekennzeichnet, daß die Klammern (15) des Warenträgers (16) etwas oberhalb der an den Platten (4) anliegenden Kanten (32) der Kippsicherungen (31) gelegen sind.

13. Vorrichtung nach einem der Ansprüche 3 - 12, gekennzeichet durch eine Ausgestaltung und automatische Steuerung der Beladestation (2) derart, daß die unten gelegenen Greif- und Transportmittel (18-20) den unten Galvanorand (4'') der senkrecht stehenden Platten freigeben, sobald die Klammern (15) des Warenträgers die Platten (4) an ihrem oben gelegenen Galvanorand (4'') ergriffen haben.

14. Vorrichtung nach einem der Ansprüche 3 bis 13, gekennzeichnet durch eine Kontrolle, z.B. durch ein Lichtschrankensystem, und Mittel, um nach Anklammerung der Platten (4) am Warenträger (16) und Abheben des Warenträgers von der Beladestation in dieser noch verbliebene Platten festzustellen und gesondert abzulegen.

15. Vorrichtung nach einem der Ansprüche 3 bis 14, dadurch gekennzeichnet, daß eine Entladestation (39) vorgesehen ist, die im wesentlichen denselben Aufbau wie die Beladestation (2) hat.

16. Vorrichtung nach Anspruch 15, dadurch gekennzeichnet, daß die Entladestation (39) oberhalb der Greif- und Transportmittel (18-20) mit Einweisungen (42) für die Anlage der Unterkanten der Platten versehen ist.

17. Vorrichtung nach Anspruch 16, dadurch gekennzeichnet, daß die Einweisungen (42) schräg zur Senkrechten und in Absenkrichtung der Platten zueinander hin verlaufen.

18. Vorrichtung nach einem der Ansprüche 3 bis 14, 16 und 17, dadurch gekennzeichnet, daß ein und dieselbe Station sowohl als Beladestation (2) und Entladestation (2') dient und wahlweise in die Position für Beladung (2), sowie in die Position für Entladung (2'), und zwar umgekehrt senkrecht zu ihrer Längsrichtung verschiebbar (41, 42) ist.

19. Vorrichtung nach einem der Ansprüche 3 bis 18, dadurch gekennzeichnet, daß die Gleit- und Transportmittel der Belade- und Entladestationen (2, 2', 39) aus einem von Rollen (18) angetriebenen Förderband (20) und Gegenandruckrollen (19) bestehen, wobei die Rollen jeweils um senkrechte Achsen umlaufen.

20. Vorrichtung nach einem der Ansprüche 3 bis 19, gekennzeichnet durch ein Öffnen und Schließen der Klammern (15) mit Hilfe je eines gegen Wirkung einer die Klammerkraft bewirkenden Feder (27) arbeitenden Druckstückes (21, 28) und eines am Warenträger (16) angreifenden Gegendruckstückes (30).

21. Vorrichtung nach einem der Ansprüche 3 bis 20, dadurch gekennzeichnet, daß im Verlauf der behandelten Platten (4) der Entladestation (39, 2') nachgeschaltet eine Ablagestation (40) mit einer Schwenkvorrichtung (45) vorgesehen ist, die in Verlängerung der Greif- und Transportmittel (18-20) der Entladestation eine Führung (48) für die senkrecht stehenden Platten besitzt und um eine parallel zur Abgaberichtung (44) der Platten verlaufende Achse (47) um 90° schwenkbar ist und die jeweilige Platte (4) in Horizontallage einer Ablage oder einer zu einer Ablage führenden Transporteinrichtung übergibt.

22. Vorrichtung nach Anspruch 21, gekennzeichnet durch eine Steuerung, welche die Platten taktweise und einzeln der Ablagestation (40) zuführt.

## Claims

1. Method for the transportation and transfer of plates (4) to be chemically treated, more especially printed circuit boards, to and onto article supports (16), which comprise clamps (15) for the detachable retention of the plates, as well as for the removal of the treated plates from the article support and their discharge, characterised in that the plates, supplied in a vertical treatment position, preferably starting in a vertical position or, in special cases, from a non-vertical initial position, are separated in this position by being mechanically gripped only at their galvanic edges (4'') and are transported below an article support (16), one behind the other, at a specific spacing (14) from one another, by horizontal conveyance by means of conveyor means (19, 20) co-operating with the lower galvanic edge, said specific spacings being adapted to the spacings and position of the clamps (15) of the article support (16), in that subsequently all of the separated plates (4) are raised together and are each gripped at the upper galvanic edge by the clamps (15) of the article support (16) and in that, after treatment of the plates in the treatment stations of a chemical or galvanic plant, the aforementioned steps are basically taken, but in the reverse order of operation, by initially releasing the plates from the article support, gripping and lowering them as well as transporting them further at predetermined intervals to a depot (40) by means of the conveyor means co-operating with the lower galvanic edge.

2. Method according to claim 1, characterised by a synchronisation of the unloading and loading times of the plates in a loading station (2) and in an unloading station (39, 2') with the time sequence of the delivery and collection of the article supports.

3. Apparatus for the transportation and transfer of plates (4) to be chemically treated, more especially printed circuit boards, having a loading station (2) and an unloading station (39), the plates at the loading station being supplied to an article support (16), which is moved by a transporter, said plates being brought to the chemical treatment station and transferred to the unloading station after the treatment in order to remove the plates from the respective article supports, to which they are detachably secured by means of clamps (15), characterised in that the stations (2, 39) comprise conveyor means (12), with which the plates are gripped at their galvanic edge from preferably a vertical delivery position, the loading station comprises means for retaining and removing again an article support, which has on the underside clamps (15) for grasping the upper galvanic edge of the plates, in that gripping and transporting means (18-20) for the joint grasping of all of the vertical plates intended for the article support are provided below the retaining position of the article support, a lifting mechanism (22, 23) is provided for raising the gripping and transporting means and the plates, which are jointly retained therein by such means for stocking an article support into the position for clamping the upper galvanic edge of the plates to the article support, and in that the structure of the unloading station corresponds to that of the loading station.

4. Apparatus according to claim 3, characterised in that the plates (4) are standing vertically, e.g. in a cassette (3), in a feed station (1), in that a pivotal means (7, 10) is provided, which extends parallel to the plane of the plates and comprises parts (10) co-operating only with the galvanic edge (4'') of the respective plates, and in that a conveying device (12), leading to the loading station (2), is provided as an extension of the plane of the plate respectively provided within the range of the pivotal means, the conveyor means of the conveying device co-operating only with a galvanic edge (4'') of the respective plate (4).

5. Apparatus according to claim 4, characterised in that, as the conveyor means, a circulatory conveyor belt co-operates with one side of the lower galvanic edge (4'') and a pressure roller, pressing against the galvanic edge, co-operates with the other side of the galvanic edge, or the pressure is applied by a second circulatory conveyor belt.

6. Apparatus according to claim 4 or 5, characterised in that the cassette (3) with the plates (4) is displaced at predetermined intervals in a direction (5) which extends perpendicular to the direction of conveyance (13) of the plates from the feed station (1) to the loading station (2), one plate entering the pivotal range of the pivotal means (7, 10) with each phase.

7. Apparatus according to one of claims 3 to 6, characterised in that means are provided for automatically controlling the movements of the plates and the component partss necessary therefor, at least the loading station (2) and the unloading stations (39, 2'), preferably also the feed station (1) and the depot (40).

8. Apparatus according to one of claims 3 to 7, characterised in that detecting and controlling means are provided, e.g. light barriers or sensors, which adjust the positioning of the plates (4) beneath the article supports (16) and their clamps (15) and adjust the size of the spacings (14) required therefor between the plates.

9. Apparatus according to one of claims 3 to 8, characterised in that the loading station (2) comprises, on each side adjacent the article support (16), stabilisers (31, 32) which are pivotable towards each other into a position which guides the upper galvanic edge (4'') of the plate and away from each other into a position which releases and does not secure the plate, and in that the stabilisers at (32) are shaped so that they touch only the upper galvanic edge of the plate (4) each time the plate is in its raised position.

10. Apparatus according to claim 9, characterised by an inclined configuration of the stabilisers with a guiding edge (32) abutting only the galvanic edge (4').

11. Apparatus according to one of claims 7 to 10, characterised in that the automatic control means both synchronously closes the clamps (15) of the article support (16) and opens the stabilisers (31, 32), and synchronously opens the above-mentioned clamps and closes the stabilisers.

12. Apparatus according to one of claims 7 to 11, characterised in that the clamps (15) of the article support (16) are situated somewhat above the edges (32) of the stabilisers (31) abutting the plates (4).

13. Apparatus according to one of claims 3 - 12, characterised by a configuration and automatic control of the loading station (2) so that the lower gripping and transporting means (18-20) release the lower galvanic edge (4'') of the vertically standing plates as soon as the clamps (15) of the article support have gripped the plates (4) at their upper galvanic edge (4'').

14. Apparatus according to one of claims 3 to 13, characterised by a monitoring system, e.g. by a light barrier system, and means for securing and separately depositing any plates (4) still remaining in the loading station after said plates have been clamped to the article support (16) and the article support has been removed from said loading station.

15. Apparatus according to one of claims 3 to 14, characterised in that an unloading station (39) is provided, which has substantially the same structure as the loading station (2).

16. Apparatus according to claim 15, characterised in that the unloading station (39), above the gripping and transporting means (18-20), is provided with guide means (42) for the abutment of the lower edges of the plates.

17. Apparatus according to claim 16, characterised in that the guide means (42) extend towards each other inclinedly relative to the vertical and in the lowering direction of the plates.

18. Apparatus according to one of claims 3 to 14, 16 and 17, characterised in that one and the same station serves both as loading station (2) and unloading station (2') and is selectively displaceable perpendicular to its longitudinal direction (41, 42) into the position for loading (2) as well as into the position for unloading (2'), and vice versa.

19. Apparatus according to one of claims 3 to 18, characterised in that the gripping and transporting means of the loading and unloading stations (2, 2', 39) comprise a conveyor belt (20), which is driven by rollers (18), and counter-pressure rollers (19), the rollers each circulating about vertical axes.

20. Apparatus according to one of claims 3 to 19, characterised by an opening and closing of the clamps (15) by means of both a pressing component (21, 28), which counteracts the effect of a spring (27) producing the clamping force, and a counter-pressing component (30) which co-operates with the article support (16).

21. Apparatus according to one of claims 3 to 20, characterised in that a depot (40) is provided with a pivoting device (45) at the outlet end when viewed with respect to the direction of the treated plates (4) of the unloading station (39, 2'), said pivoting device having, as an extension of the gripping and transporting means (18-20) of the unloading station, a guide means (48) for the vertically standing plates and is pivotable through 90° about an axis (47) extending parallel to the discharge direction (44) of the plates, and said guide means transfers the respective plate (4), in the horizontal position, to a depot or to a transporting arrangement leading to a depot.

22. Apparatus according to claim 21, characterised by a control means, which supplies the plates at predetermined intervals and individually to the depot (40).

## Revendications

1. Procédé de transport et de dépose de plaques (4) devant subir un traitement chimique, en particulier de plaques de circuits imprimés, vers et sur des supports d'article (16) qui présentent des pinces (15) pour le maintien amovible des plaques, ainsi que de retrait des plaques traitées du support d'article et d' évacuation de celles-ci, caractérisé en ce que les plaques délivrées de préférence dans une position verticale ou, dans des cas particuliers, dans une position verticale à partir d'une position de départ non verticale, sont séparées dans cette position par préhension par machine de leurs seuls bords de galvanisation (4'') et transportées sous un support d'article (16) à une distance définie (14) les unes des autres par un transport horizontal au moyen de moyens de transport (19, 20) se mettant en prise sur le bord de galvanisation inférieur, ces distances définies étant accordées aux distances et à la position des pinces (15) du support d'article (16), en ce que toutes les plaques (4) séparées sont ensuite soulevées ensemble et saisies chacune par les pinces (15) du support d'article (16) sur le bord de galvanisation supérieur et en ce qu'après le traitement des plaques dans les postes de traitement d'une installation chimique ou galvanique, les mesures expliquées ci-dessus se déroulent en principe, mais selon un déroulement inverse des fonctions en commençant par le dégagement des plaques du support d'article, puis la préhension et l'abaissement ainsi que la poursuite du transport cadencé au moyen des moyens de transport se mettant en prise sur le bord de galvanisation inférieur jusqu'à un dépôt (40).

2. Procédé selon la revendication 1, caractérisé en ce qu'il comporte l'harmonisation des temps de déchargement et de chargement des plaques dans un poste de chargement (2) et un poste de déchargement (39, 2') avec la séquence d'amenée et de retrait des supports d'article.

3. Dispositif pour le transport et la dépose de plaques (4) devant subir un traitement chimique, en particulier de plaques de circuits imprimés, avec un poste de chargement (2) et un poste de déchargement (39), dans lequel les plaques sont amenées, dans le poste de chargement, à un support d'article (16) déplacé par le chariot de transport et amenées au poste de traitement et sont transportées après le traitement au poste de déchargement en vue de retirer les plaques des supports d'article auxquels elles sont fixées de manière amovible au moyen de pinces (15), caractérisé en ce que les postes (2, 39) présentent des moyens de transport (12) avec lesquels les plaques sont saisies sur leur bord de galvanisation, de préférence à partir d'une position d'arrivée verticale, et le poste de chargement présente des moyens de suspension et de soulèvement d'un support d'article, qui possède sur sa face inférieure des pinces (15) destinées à saisir le bord de galvanisation supérieur des plaques, en ce qu'il est prévu en dessous de la position de suspension du support d'article des moyens de préhension et de transport (18-20) destinés à saisir ensemble toutes les plaques verticales destinées au support d'article, un mécanisme de levage (22, 23) est prévu sur le support d'article pour soulever les moyens de préhension et de transport et les plaques maintenues ensemble par ceux-ci en vue de garnir un support d'article dans la position permettant le serrage du bord de galvanisation supérieur des plaques, et en ce que la construction du poste de déchargement correspond à celle du poste de chargement.

4. Dispositif selon la revendication 3, caractérisé en ce que les plaques (4) s'étendant verticalement dans un poste de remise (1), c'est-à-dire dans une cassette (3), et en ce qu'il est prévu un moyen de basculement (7, 10) parallèle au plan des plaques, qui présente des parties (10) se mettant en prise seulement sur le bord de galvanisation (4'') de chaque plaque, et en ce que dans le prolongement du plan de chaque plaque prévue dans la zone du moyen de pivotement, il est prévu un dispositif de transport (12) menant au poste de chargement (2), les moyens de transport du dispositif de transport se mettant en prise seulement sur un bord de galvanisation (4'') de chaque plaque (4).

5. Dispositif selon la revendication 4, caractérisé en ce que les moyens de transport qui se mettent en prise sur un côté du bord de galvanisation (4'') inférieur sont formés d'une courroie transporteuse continue et ceux qui se mettent en prise de l'autre côté du bord de galvanisation par un rouleau presseur qui appuie contre celui-ci, ou bien la pression est exercée par une deuxième courroie transporteuse continue.

6. Dispositif selon la revendication 4 ou 5, caractérisé en ce que la cassette (3) se déplace de façon cadencée avec les plaques (4) dans une direction perpendiculaire au sens de transport (13) des plaques du poste de remise (1) au poste de chargement (2), une plaque parvenant dans la zone de pivotement du moyen de pivotement (7, 10) à chaque temps de la cadence.

7. Dispositif selon l'une quelconque des revendications 3 à 6, caractérisé en ce qu'il est prévu des commandes automatiques des mouvements des plaques et des composants nécessaires à ceux-ci, au moins ceux du poste de chargement (2) et du poste de déchargement (39, 2'), de préférence aussi ceux du poste de dépose (1) et du pose de dépôt (40).

8. Dispositif selon l'une quelconque des revendications 3 à 7, caractérisé en ce que des moyens de détection et de commande, par exemple des barrages photoélectriques ou des capteurs, sont prévus pour régler le positionnement des plaques (4) en dessous des supports d'article (16) et des pinces (15) de ceux-ci et la grandeur des écarts (14) entre les plaques nécessaires à cette fin.

9. Dispositif selon l'une quelconque des revendications 3 à 8, caractérisé en ce que le poste de chargement (2) présente de chaque côté près du support d'article (16) des sécurités contre le basculement (31, 32) qui peuvent pivoter l'une vers l'autre dans une position qui guide le bord de galvanisation (4'') supérieur de la plaque et s'écarter l'une de l'autre dans une position qui libère et ne maintient pas la plaque, et en ce que les sécurités contre le basculement sont conformées de telle sorte (32) qu'elles ne touchent que le bord de galvanisation supérieure de la plaque (4) dans chaque position de levage de celle-ci.

10. Dispositif selon la revendication 9, caractérisé en ce que les sécurités contre le basculement sont orientées en oblique avec un seul bord de guidage (32) reposant sur le bord de galvanisation (4').

11. Dispositif selon l'une quelconque des revendications 7 à 10, caractérisé en ce que la commande automatique ferme de manière synchrone les pinces (15) du support d'article (16) et ouvre les sécurités contre le basculement (31, 32), de même qu'elle ouvre lesdites pinces et ferme les sécurités contre le basculement de manière synchrone.

12. Dispositif selon l'une quelconque des revendications 7 à 11, caractérisé en ce que les pinces (15) du support d'article (16) se trouvent légèrement au-dessus des bords (32) des sécurités contre le basculement (31) reposant sur les plaques (4).

13. Dispositif selon l'une quelconque des revendications 3 à 12, caractérisé en ce que la conception et la commande automatique du poste de chargement (2) sont telles que les moyens de préhension et de transport (18-20) situés dessous dégagent le bord de galvanisation (4'') inférieur des plaques verticales dès que les pinces (15) du support d'article ont saisi les plaques (4) sur leur bord de galvanisation (4'') supérieur.

14. Dispositif selon l'une quelconque des revendications 3 à 13, caractérisé en ce qu'il comporte un contrôle, par exemple par un système de barrage photoélectrique, et des moyens pour déterminer, après le serrage des plaques (4) sur le support d'article (16) et le levage du support d'article à partir du poste de chargement, les plaques qui restent encore dans celui-ci et les déposer séparément.

15. Dispositif selon l'une quelconque des revendications 3 à 14, caractérisé en ce qu'il est prévu un poste de déchargement (39) qui a sensiblement la même structure que le poste de chargement (2).

16. Dispositif selon la revendication 15, caractérisé en ce que le poste de déchargement (39) est pourvu au-dessus des moyens de préhension et de transport (18-20) de repères (42) pour l'appui des bords inférieurs des plaques.

17. Dispositif selon la revendication 16, caractérisé en ce que les repères (42) sont orientés en oblique par rapport à la verticale et les uns vers les autres dans le sens de l'abaissement des plaques.

18. Dispositif selon l'une quelconque des revendications 3 à 14, 16 et 17, caractérisé en ce qu'un seul et même poste sert aussi bien de poste de chargement (2) que de poste de déchargement (2') et peut être sélectivement amené dans la position de chargement (2) ainsi que dans la position de déchargement (2'), en sens inverse perpendiculairement à son orientation longitudinale (41, 42).

19. Dispositif selon l'une quelconque des revendications 3 à 18, caractérisé en ce que les moyens de glissement et de transport des postes de chargement et de déchargement (2, 2', 39) se composent d'une courroie de transport (20) entraînée par des rouleaux (18) et de rouleaux de contre-appui (19), les rouleaux tournant autour d'axes verticaux.

20. Dispositif selon l'une quelconque des revendications 3 à 18, caractérisé en ce que l'ouverture et la fermeture des pinces (15) se fait à l'aide d'une pièce d'appui (21, 28) pour chacune qui agit contre un ressort (27) exerçant la force de serrage.

21. Dispositif selon l'une quelconque des revendications 3 à 20, caractérisé en ce qu'il est prévu sur le trajet des plaques traitées (4) en aval du poste de déchargement (39, 2') un poste de dépôt (40) pourvu d'un mécanisme pivotant (45) qui possède, dans le prolongement des moyens de préhension et de transport (18-20) du poste de déchargement, un guide (48) pour les plaques disposées verticalement et qui peut pivoter de 90° autour d'un axe (47) parallèle au sens de dépose (44) des plaques et remet chaque plaque (4) en position horizontale à un dépôt ou à un dispositif de transport menant à un dépôt.

22. Dispositif selon la revendication 21, caractérisé en ce qu'il comporte une commande qui amène les plaques au poste de dépôt (40) une par une et de manière cadencée.
